(19) Europäisches Patentamt / European Patent Office / Office européen des brevets

(11) **EP 4 407 685 B1**

(12) **EUROPEAN PATENT SPECIFICATION**

(45) Date of publication and mention
of the grant of the patent:
**12.11.2025  Bulletin 2025/46**

(21) Application number: **23152976.9**

(22) Date of filing: **24.01.2023**

(51) International Patent Classification (IPC):
**H10F 39/12** (2025.01)    **H10F 39/00** (2025.01)

(52) Cooperative Patent Classification (CPC):
**H10F 39/193; H10F 39/022**

---

(54) **IMAGING SENSOR COMPRISING QUANTUM DOTS, SENSOR SYSTEM AND METHOD FOR MANUFACTURING AN IMAGING SENSOR**

ABBILDUNGSSENSOR MIT QUANTENPUNKTEN, SENSORSYSTEM UND VERFAHREN ZUR HERSTELLUNG EINES ABBILDUNGSSENSORS

CAPTEUR D'IMAGERIE COMPRENANT DES POINTS QUANTIQUES, SYSTÈME DE CAPTEUR ET PROCÉDÉ DE FABRICATION D'UN CAPTEUR D'IMAGERIE

---

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**31.07.2024  Bulletin 2024/31**

(73) Proprietor: **Ludwig-Maximilians-Universität München**
**80539 München (DE)**

(72) Inventor: **AMIN, Amir Y.**
**80539 München (DE)**

(74) Representative: **Prinz & Partner mbB**
**Patent- und Rechtsanwälte**
**Rundfunkplatz 2**
**80335 München (DE)**

(56) References cited:
**EP-A1- 3 979 333       US-A1- 2005 205 879**
**US-A1- 2008 315 339    US-A1- 2018 342 647**

---

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to an imaging sensor comprising light-sensitive detector elements with quantum dots, a sensor system comprising such an imaging sensor and a method for manufacturing an imaging sensor.

In spectroscopy applications, a sample is irradiated with light, i.e. electromagnetic radiation of a given range of wavelengths defining a light spectrum. By interaction of the sample with the light, e.g. by absorption, the light spectrum is characteristically changed, such that information about the sample can be derived from the changed light spectrum.

A core component of any given spectroscopy setup is the imaging sensor which is used to detect the light after interaction with the sample. Typically, imaging sensors comprise a multitude of small light-sensitive areas (also termed "pixels") spread along one or two axes of the imaging sensor. The signals obtained from each individual pixel is then used to assemble an overall image of the area of interest.

E.g., in NIR (near-infrared) applications, InGaAs-based multi-channel array detectors are used for detecting infrared light due to their high sensitivity to light in the NIR spectrum.

In a typical spectrometer, the light for detection is spread as a function of its wavelength by an optical element like a grating along at least one of the axes of the imaging sensor. Thus, the pixel at one end of the respective axis will be irradiated with light of a minimum wavelength, the neighboring pixel with light of a slightly higher wavelength, the next-neighboring pixel with light of an even slightly higher wavelength and so on until the pixel at the other end of the respective axis will be irradiated with light of a maximum wavelength.

Known imaging sensors suffer from limitations based on their performance and their spectral response, which can be expressed in terms of their responsivity. The responsivity measures an input-output gain of a given imaging sensor and is a ratio between the electrical output power and the optical input power. Here, the responsivity is expressed in terms of current responsivity $R_i$ which can be expressed by the following equation (1):

$$R_i = \frac{\Delta I}{P_{in}} = \frac{q\left(\frac{\eta}{h\nu}\right)\tau_n}{\tau_t} \tag{1}$$

in which $\Delta I$ is the created output current, $P_{in}$ is the optical input power, q is the electron charge, $\eta$ is the quantum efficiency (i.e., the conversion efficiency of photons to electrons), h is Planck's constant and $\nu$ is the frequency of the respective light. The ratio $\tau_n/\tau_t$ describes the photoconductive gain. In case this ratio is bigger than one, the responsivity is increased.

In commercially available imaging sensors based on InGaAs, the spectral response or responsivity is less than 1 A/W over considerable parts of the VIS and NIR spectrum. This directly influences the specific detectivity of the imaging sensor, which describes the smallest optical input which can be sensed by the detector, wherein the smallest optical input power (also called "noise equivalent power" $P_{NEP}$) can be described as $P_{NEP} = I_{noise}/R_i$, wherein $I_{noise}$ defines electrical noise which is a random variable resulting from stochastic or random processes associated with various particles.

In the last years, alternatives to InGaAs-based detector elements have been investigated, e.g. Bulk PbS NIR-sensitive materials, PbS quantum dots, combinations of graphene and PbS quantum dots and NIR sensitive polymers. However, none of these alternatives reach the same performance as InGaAs-based detector elements.

US 2008/315339 A1 shows a solid-state imaging device comprising a light-receiving portion formed in a semiconductor substrate, wherein in the light-receiving portion a photoelectric conversion of incoming light is carried out. The imaging device further comprises an optical filter layer in which quantum dots having substantially equal diameters are formed, wherein the quantum dots have higher refractive indexes than the refractive index of the optical filter layer.

EP 3 979 333 A1 discloses an optical sensor comprising a photoelectric conversion element and an optical member provided on a light-incident side with respect to the photoelectric conversion element. The optical sensor includes quantum dots with a maximum absorption wavelength in an infrared range having a wavelength of 800 nm or longer while the optical member is an infrared transmitting member having a high transmittance for light having a wavelength of 800 nm or longer and a low transmittance for light in a wavelength range of 400 to 650 nm.

From US 2005/205879 A1, a photoelectric converting film stack type solid-state image pickup device is known which comprises a semiconductor substrate, in which a signal read circuit is formed, and one or more photoelectric converting films stacked above each other in the direction of an incident light beam, wherein each of the photoelectric converting films comprises a quantum dot contributing to the photoelectric conversion and a material having a band gap larger than that of the quantum dot.

US 2018/342647 A1 describes quantum dots comprising a core quantum dot, a first semiconductor shell consisting of ZnS or ZnSe and a second semiconductor shell comprising a second semiconductor material different from the first semiconductor shell and comprising a group II to VI compound. The quantum dot can be part of an ink further including a liquid vehicle.

The object of the invention is to provide an imaging sensor with high responsivity, especially with a uniform responsivity over extended parts of the light spectrum.

The object of the invention is solved by an imaging sensor comprising a plurality of light-sensitive detector elements being arranged in an array structure, the detector elements comprising quantum dots, wherein the average diameter of the quantum dots of the detector elements increase along an array axis of the array structure such that each of the detector elements along the array axis has an absorption maximum at a different pre-determined wavelength.

The invention is based on the idea to use a multitude of different sized quantum dots along the array structure of the imaging sensor such that at every point along the array axis quantum dots are used which are optimal for the light of the specific wavelength irradiated on the respective point of the imaging sensor along the array axis. Termed differently, the imaging sensor according to the invention uses selective quantum dots with a tuned size at selected positions along the array axis for increasing the quantum efficiency at each individual wavelength detectable by the imaging sensor, thereby optimizing the overall responsivity of the imaging sensor. This effect is based on the effect that quantum dots show an absorption maximum at a wavelength which is dependent on the size of the quantum dots.

In contrast, in conventional InGaAs-based imaging sensors, the same type of InGaAs-based detector element is used at all pixels of the imaging sensor. Thus, wavelengths at which the respective kind of detector element has a low responsivity cannot be compensated for, leading to an overall suboptimal responsivity of the conventional imaging sensor.

The detector elements are also termed "pixels", wherein the totality of pixels define the picture obtained by the imaging sensor.

The average diameter of the quantum dots can be determined by taking a TEM-image of the respective detector element, measuring the individual quantum dot diameter throughout the detector element and calculating the average value of the measured individual quantum dot diameters.

Generally, the term "quantum dot" defines a crystalline material having a size of several nanometers and which is composed of hundreds to thousands of atoms. Due to the small size of these materials, most of the atoms are present on or near the surface of the quantum dots which leads to electronic, optical, chemical and mechanical properties different from those of a bulk crystalline material due to quantum confinement effects.

Each detector element can comprise at least two sub-elements, wherein all sub-elements of a detector element comprise quantum dots of the same average diameter. The use of several sub-elements can at least partially compensate for effects of limited resolution of light falling onto the imaging sensor.

The term "same average diameter" means that the quantum dots within all sub-elements of the detector element have the same average diameter wherein unavoidable variations due to the manufacturing process of the imaging sensor are ignored.

The quantum dots can comprise a semiconductive material, the semiconductive material preferably being selected from the group consisting of PbS, PbSe, HgTe, InAs, InSb, CdS, CdSe and combinations thereof, more preferably wherein the semiconductive material of the quantum dots is PbS. Quantum dots of these materials show an absorption maximum at wavelengths typically needed in spectroscopy applications, especially for VIS- and/or NIR-applications. Further, quantum dots of selected sizes can be efficiently prepared from these materials by synthesis routes known in the art.

To improve the conductivity of the quantum dots in the detector element, the quantum dots can have a core-shell structure. Further, using quantum dots with a core-shell structure can improve the robustness and/or lifetime of the imaging sensor.

The core preferably comprises the semiconductive material.

The shell preferably comprises ligands bonded to the core. The ligand can be chosen from the group of carboxylic acids, thioles, amines, organic salts and combinations thereof.

The carboxylic acid is preferably selected from the group of saturated or unsaturated fatty acids having a chain length of from 2 to 22 carbon atoms. E.g., the carboxylic acid can be selected from the group consisting of lauric acid, myristic acid, stearic acid, oleic acid and combinations thereof. Most preferably, the carboxylic acid is oleic acid.

The thiol is preferably selected from the group of saturated or unsaturated thiols having a chain length of from 2 to 8 carbon atoms. Most preferably, the thiol is ethanedithiol, 3-mercaptopropionic acid or a combination thereof.

The amine is preferably selected from the group of saturated and unsaturated amines having a chain length of from 2 to 20 carbon atoms. Most preferably, the amine is butylamine, oleylamine or a combination thereof.

The organic salt preferably is selected from the group of quaternary ammonium salts. Most preferably, the organic salt is a tetrabutylammonium salt, a cetyltrimethyl ammonium salt or a combination thereof, e.g. cetyltrimethyl ammonium bromide.

The average diameter of the quantum dots can be within the range of from 3 to 20 nm. Quantum dots of this size range show absorption maxima in the VIS- to NIR-range of the light spectrum, thereby rendering these materials especially suitable for VIS- and/or NIR-spectroscopy applications.

Generally, the shape of the quantum dots is not restricted, as long as they show the desired absorption behavior.

In one variant, the quantum dots have a circular or a polygonal shape. The polygonal shape is e.g. a five- or six-sided polygonal shape. The polygonal shape is defined as the contour of the outer edge of the respective quantum dot in a two-dimensional TEM-image.

The imaging sensor especially is an NIR imaging sensor, preferably wherein the imaging sensor is adapted to detect light having a wavelength in a target range of from 500 to 3000 nm, more preferably of from 800 to 2500 nm.

The "target range" defines the target spectrum of the imaging sensor.

The imaging sensor can have a responsivity of 1 or more over at least 85% of the target range, preferably over at least 90 % of the target range. In this way, the imaging sensor provides an especially high overall sensitivity.

The object of the invention is further solved by a sensor system comprising the imaging sensor as described above being adapted to detect light from an incident light beam and at least one optical element configured to guide the incident light beam onto the imaging sensor.

The properties and advantages of the imaging sensor according to the invention also apply to the sensor system according to the invention and vice versa and it is referred to the explanations given above.

The at least one optical element especially comprises an optical slit or optical filter and a grating. The optical slit or optical filter limits the size and/or intensity of an incoming light beam. The grating is used for generating a dispersed incident light beam which is detected by the imaging sensor.

The pre-determined wavelengths of the quantum dots used in the imaging sensor is especially defined by the resolution of the grating. Termed differently, the grating can determine the available dispersion resolution and the quantum dots in the respective detector elements are chosen such to optimally correspond to the available wavelength resolution. Generally, the resolution of the sensor system is determined by the resolution of the grating, as commercially available gratings typically have a resolution of 5 to 10 nm.

The object of the invention is also solved by a method for manufacturing an imaging sensor comprising a plurality of light-sensitive detector elements being arranged in an array structure, the detector elements comprising quantum dots, the method comprising the steps of:

a) choosing a plurality of pre-determined wavelengths within a target wavelength range,

b) providing a quantum dot precursor having an average diameter corresponding to one of the pre-determined wavelengths,

c) preparing an ink formulation comprising the quantum dot precursor and a solvent, and

d) applying the ink formulation on a substrate, thereby forming one of the plurality of detector elements comprising quantum dots,

wherein steps b) to d) are repeated for each of the pre-determined wavelengths and wherein the ink formulations are applied on the substrate such that the average diameter of the quantum dots in the formed detector elements increases along an array axis of the array structure.

The imaging sensor especially is an imaging sensor as described above.

The method according to the invention provides an easy and reliable way of applying quantum dots of selected sizes having absorption maxima at the pre-determined wavelengths onto the substrate, thereby obtaining an imaging sensor of optimal responsivity and sensitivity. Termed differently, the method according to the invention is based on a combination of using selectively sized quantum dots with a method of additive manufacturing, e.g. inkjet printing of ink formulations comprising quantum dots.

Generally, the method for applying the ink formulation on the substrate is not limited, as long as the respective ink formulation can be reliably applied on the substrate. E.g., the ink formulation can be applied by blade coating, slot die coating, spray coating and/or inkjet printing.

The quantum dot precursor can comprise colloidal quantum dots within a solvent. The colloidal quantum dots can be capped by a ligand such to form a core-shell structure. Quantum dot precursors can be prepared in advance and stored for extended period of times, especially if core-shell structured quantum dots are used. Thus, the necessary quantum dot precursors can be flexibly chosen before the respective manufacturing process at hand.

The solvent can be chosen from the group consisting of N,N-dimethylformamide, hexylamine, butylamine, phenylethylamine, dimethylsulfoxide and combinations thereof.

The solvent used in the ink formulation preferably has a boiling point of 130 °C or less. Solvents or solvent mixtures with a boiling point of 130 °C or less provide a fast solidification of the ink formulation on the substrate after application, thereby reducing the amount of material movement between application of the ink and ink solidification and thus increasing the homogeneity of the formed detector element.

For increasing the density of quantum dots within the detector elements, the quantum dot precursor can have a concentration of at least 300 mg/mL in the ink formulation, preferably of at least 400 mg/mL.

The substrate can be a finger-structure electrode. Such electrodes lead to an especially easy and fast manufacturing method, as no additional steps other than applying the ink formulation on the finger-structure electrode and drying the ink formulation has to be applied to obtain a functional imaging sensor.

E.g., the detector element can be a photoresistor device.

It is also possible that the substrate comprises a metal oxide layer on which the ink formulation is applied. Thus, the quantum dots will be on top of the metal oxides, forming a multiple layer structure with the substrate.

The kind of substrate is generally not limited, as long as the ink formulation can be homogenously applied on the respective substrate.

Further features and advantages of the invention will become more apparent from the following detailed description of exemplary embodiments, which are not be understood as limiting, the experiments and Figures.

- Fig. 1 schematically shows a sensor system according to the invention comprising an imaging sensor according to the invention,

- Fig. 2 schematically shows the imaging sensor of Fig. 1 in more detail.

- Fig. 3 shows a diagram depicting the responsivity of the imaging sensor of Fig. 1 as a function of wavelength,

- Fig. 4 shows a TEM image of quantum dots used in the imaging sensor of Fig. 1 applied on a substrate,

- Fig. 5 shows a diagram highlighting the size distribution of the quantum dots in Fig. 4,

- Fig. 6 shows an absorption spectrum of one type of quantum dots used in the imaging sensor of Fig. 1, and

- Fig. 7 shows a block diagram of a method according to the invention for manufacturing the imaging sensor of Fig. 1.

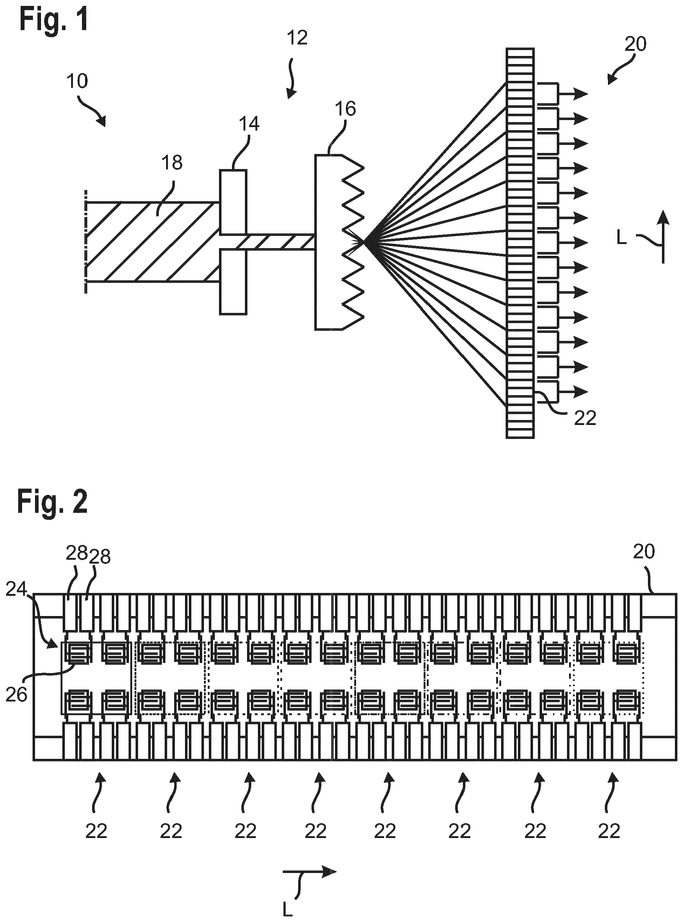

In Fig. 1, a schematic depiction of selected parts of a sensor system 10 according to the invention is shown.

The sensor system 10 comprises several optical elements 12, wherein in the embodiment shown in Fig. 1 the sensor system 10 comprises an optical slit 14 and a grating 16 as optical elements 12.

The optical slit 14 is used to limit the size and of an incoming light beam 18 before said incident light beam 18 falls upon the grating 16. The grating 16 disperses the incident light beam 18. The dispersed incident light beam 18 is then directed onto an imaging sensor 20 according to the invention.

Of course, the kind of optical elements 12, the number of optical elements 12 and their relative arrangement can differ from the exemplary embodiment shown in Fig. 1.

The imaging sensor 20 comprises a plurality of light-sensitive detector elements 22 which are arranged in an array structure along an array axis L of the imaging sensor 20.

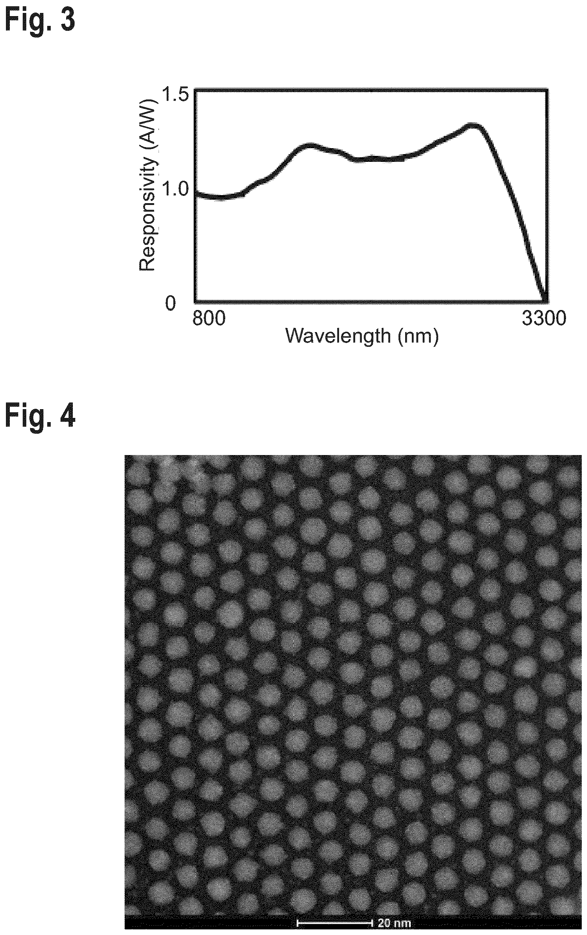

Each of the detector elements 22 comprises quantum dots (see Fig. 4), wherein the size of the quantum dots generally increase along the array axis L. E.g., the average diameter of the quantum dots is within a range of from 3 to 20 nm.

The quantum dots comprise a semiconductive material, the semiconductive material being selected from the group consisting of PbS, PbSe, HgTe, InAs, InSb, CdS, CdSe and combinations thereof.

Due to the different sizes of the quantum dots, the absorption maximum of the respective quantum dots, i.e. the wavelength for which the respective quantum shows the highest responsivity, also changes along the array axis L of the imaging sensor 20.

According to the invention, the average diameter of the quantum dots along the array axis L (and therefore the absorption maxima of the quantum dots) is chosen such that the position of each of the detection elements 22 along the array axis L is matched with the wavelength of the incident light beam 18 after it has been dispersed by the grating 16. Termed differently, each of the detector elements 22 has an absorption maximum at or close to the wavelength of the light which is directed by the grating 16 on the respective detector element 22.

Fig. 2 shows a further schematic depiction of the imaging sensor 20 with more details.

Each of the detector elements 22 comprises a plurality of sub-elements 24, in the shown embodiment a total of four sub-elements 24, as indicated in Fig. 2 by rectangles having differing contours. Of course, each of the detector elements 22 can also comprise a lower or higher number of detector elements 22.

Each of the sub-elements 24 is a finger-structure electrode which acts as a substrate 26 for the quantum dots. The finger-structure electrodes are connected via connection terminals 28 to (not shown) read-out electronics of the imaging sensor 20. Accordingly, a charge built up in the quantum dots on the substrate upon irradiation can be quantified and evaluated.

Within each of the detector elements 22, quantum dots of the same average diameter are applied on the finger-structure electrodes, wherein the average diameter is increasing along the array axis L, such that each of the detector elements 22 has an absorption maximum at a pre-determined wavelength.

E.g., the detector element 22 depicted at the left-hand side of Fig. 2 is the detector element 22 with the smallest quantum dots and therefore with an absorption maximum at the lowest wavelength compared to all other quantum dots used in the imaging sensor. The detector element 22 depicted at the righthand side of Fig. 2 is the detector element 22 with the largest quantum dots and therefore with an absorption maximum at the highest wavelength compared to all other quantum dots used in the imaging sensor.

In Fig. 2, an imaging sensor 20 having a total of eight detector elements 22, each having four sub-elements 24, is shown. Of course, the number of detector elements 22 can be lower or higher than shown in Fig. 2. E.g., the imaging sensor 20 can comprise up to several thousand of detector elements 22.

Preferably, the number of detector elements 22 is matched to the resolution of the grating 16, i.e. the number of detector elements 22, the number of sub-elements 24 within each detector element 22 and/or the spacing between two detector elements 22 is chosen to correspond to the resolution of grating 16.

Fig. 3 shows a diagram depicting the responsivity of an embodiment of the imaging sensor 20 according to the invention as a function of wavelength. As can be seen, the imaging sensor 20 achieves a responsivity of 1.0 or more over most of the spectrum in the range of from 800 to 3300 nm.

For this measurement, a linear array imaging sensor with quantum dots of 18 different average diameters, i.e. having 18 different absorption maxima, has been used, wherein the overall detection range of the imaging sensor was from 400 to 3300 nm.

For determining the power input $P_{in}$ of the used light source as function of wavelength, a calibration measurement was done over the relevant spectrum using a combination of conventional imaging sensors based on silicon, InGaAs and pyroelectric thermodetectors, respectively, to cover the whole target spectrum from visible to the mid-infrared regime. Then, the current output $\Delta I$ using the linear imaging sensor with quantum dots was measured as a function of wavelength and the responsivity was calculated according to formula (1) as described above.

In the following, a method for manufacturing the image sensor as described above is presented.

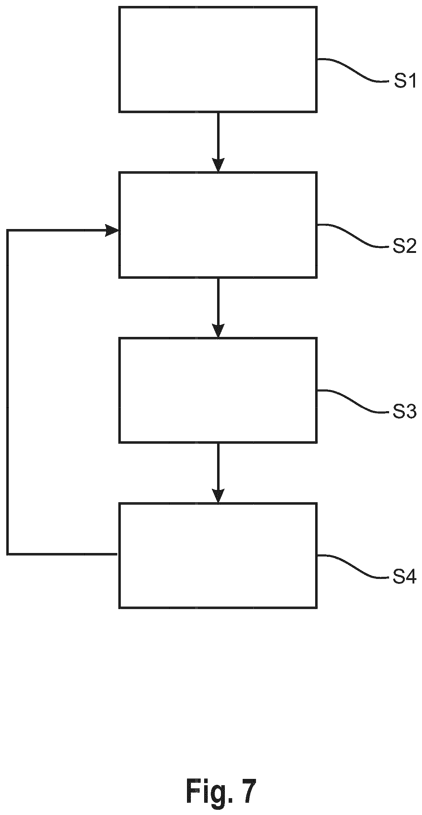

First, as step a), a plurality of pre-determined wavelengths within a target wavelength range is chosen (see step S1 in Fig. 7). The target wavelength range is determined based on the intended application of the imaging sensor 20.

E.g., the imaging sensor 20 is an NIR imaging sensor which is supposed to detect light having a wavelength in a target range of from 500 to 3000 nm. Thus, the pre-determined wavelengths need to be chosen within said target range, preferably equally spaced within the target range.

Second, as step b), a quantum dot precursor having an average diameter corresponding to one of the pre-determined wavelengths is provided (see step S2 in Fig. 7). Preparation methods for quantum dot precursors are known in the art. One example for preparing a quantum dot precursor will be described later.

As step c), an ink formulation comprising the quantum dot precursor and a solvent is prepared (see step S3 in Fig. 7).

The solvent is especially chosen from the group consisting of N,N-dimethylformamide (DMF), hexylamine (HEX), butylamine (BTA), phenylethylamine (PEA), dimethylsulfoxide (DMSP) and combinations thereof.

Finally, as step d), the ink formulation is applied on the substrate 26, i.e. on the finger-structure electrodes 24 of one of the detector elements 22 in the shown embodiment, thereby forming one of the plurality of detector elements 22 (see step S4 in Fig. 7).

Steps b) to d) are then repeated for each of the pre-determined wavelengths to form all of the detector elements 22, such that the average diameter of the quantum dots increase along the array axis L of the array structure.

Of course, the iteration of steps b) to d) can also be done in an interleaved manner. E.g., at least some of the ink formulations can already be prepared when one of the ink formulation is currently already applied on the substrate.

Experiments

Synthesis of quantum dots

For the synthesis of PbS quantum dots with an absorption edge at about 1700 nm, a 250 mL three-neck flask is filled with 900 mg (4 mmol) PbO and 30.35 mL (95 mmol) 1-octadecene inside of a nitrogen filled glovebox. Afterwards, the flask is mounted onto a Schlenk line, evacuated and flushed with nitrogen for three times. Under nitrogen flow, 37.8 g (144 mmol) oleic acid is added. The solution is heated to 150°C under vacuum for one hour. During this time, the solution is degassed and the yellow color disappeared, meaning that the lead oleate precursor is formed.

Afterwards, the solution is cooled to 120°C under a nitrogen atmosphere. The sulfur precursor solution, consisting of 420 μL (2 mmol) bis-(trimethylsilyl)-sulfide (TMS-S) in 5.0 mL (15.6 mmol) 1-octadecene, is injected into the lead oleate precursor solution and the reaction was stirred for exactly 5 minutes, then quenched in an ice bath for at least 2.5 minutes.

For purification, the solution is loaded into four centrifuge tubes. The quantum dots (QDs) in each tube are precipitated with 10 mL ethanol and 10 mL acetone, followed by centrifugation (7860 rpm, 10 minutes) and discarding the supernatant. The washing process was repeated twice by redispersing the sediment in 15 mL octane using the vortex and precipitating the PbS quantum dots with 10 mL ethanol and 10 mL acetone, followed by centrifugation (7860 rpm, 10 minutes) and removing the supernatant.

The PbS quantum dots in the sediment are dried in vacuum and redispersed in toluene at a concentration of 40 mg/mL for long-term storage.

For the synthesis of PbS quantum dots with an absorption edge at about 950 nm for the HTL, minor changes during the synthesis method described above are employed.

900 mg PbO are dissolved in 52.5 mL 1-octadecene and 3.2 mL oleic acid is used as the ligand. The sulfur precursor solution was not changed, i.e. 420 $\mu$L TSM-S in 5 mL 1-octadecene. During the injection, the temperature was lowered to 100°C. All other steps are kept the same as described above.

From the above, it is clear that the same procedure can be followed for obtaining PbS quantum dots of a target size having an absorption maximum at a pre-determined wavelength.

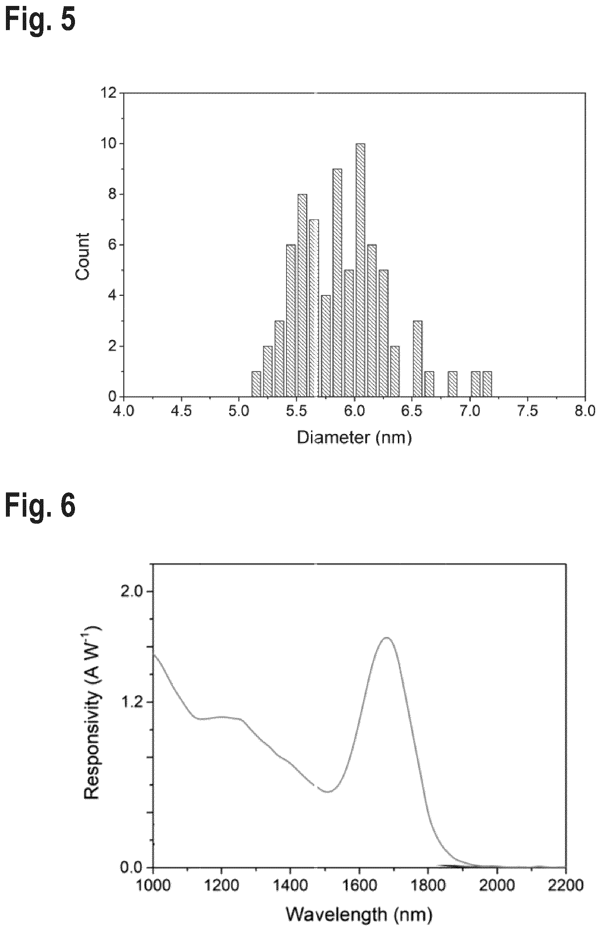

Fig. 4 shows a TEM image of oleate-capped PbS quantum dots with an absorption edge of 1710 nm and Fig. 5 a histogram of a representative region from the TEM image comprising a total of 75 quantum dots with an average diameter of $5.91 \pm 0.41$ nm.

From these Figures, it becomes evident that PbS quantum dots can be synthesized such to obtain a precise size control of the synthesized quantum dots.

Synthesis of core-shell quantum dots

The synthesized oleate-capped PbS quantum dots in toluene are precipitated with acetone, dried and dissolved in octane at a concentration of 60 mg/mL. Furthermore, 922 mg (2 mmol) $PbI_2$, 146.8 mg (0.5 mmol) $PbBr_2$ and 72.2 mg (0.88 mmol) sodium acetate are dissolved in 20 mL DMF as ligand precursor solution.

Two centrifuge tubes are loaded with 30 mL octane, 1 mL of the oleate-capped PbS in octane and 10 mL of the ligand precursor solution each. The tube is shaken for 30 s by hand, centrifuged (7860 rpm, 30 sec) and the octane phase is removed.

During this step, the octane phase became clear and the quantum dots moved into the polar DMF phase. To remove all organic ligand impurities, the DMF phase is washed three times. Each step consisted of the addition of 10 mL octane, shaking for 30 seconds, centrifugation and final removal of the octane phase. In the last step, all solvents, i.e. the octane and DMF phase, are removed.

The quantum dots are partially redispersed in 250 $\mu$L DMF by vortexing. For full dissolution, 10 $\mu$L of BTA is added. The solution of both tubes is moved into a single 2 mL centrifuge tube, in which the quantum dots are precipitated with 800 $\mu$L toluene and centrifuged at 13.000 rpm for 3 minutes.

Afterwards, the PbS quantum dots are dissolved in 500 $\mu$L DMF and 10 $\mu$L BTA, precipitated with 1 mL toluene and centrifuged at 13.000 rpm for 5 minutes.

Ink formulation and application

The pellet obtained from synthesis of core-shell quantum dots is moved into a glass vial and an ink is prepared by adding a suitable solvent.

Possible solvent mixtures include DMF:DMSP:BTA:PEA and HEX:DMF:BTA.

An ink consisting of DMF:HEX:BTA in the ratio of 1:1:1 (v/v) has an approximate boiling point of 120°C which ensures a fast film solidification.

The concentration for the thin film fabrication is 450 mg/mL.

The ink can be directly applied onto the substrate and the solvent be evaporated to form the quantum dots on the substrate.

To remove further remaining particles, the ink can be centrifuged exactly 30 s and the supernatant is used for the application of the ink, e.g. by blade coating.

Photoconductivity experiments

Photoconductivity experiments were done with a tungsten lamp used as illumination source which was mono-achromatized by a grating spectrometer ("Acton SP 2150" from "Princeton" company). The output tuned light obtained from the grating spectrometer was modulated with a mechanical chopper. On the sample side, the detector was biased with a "Keithley 236 SMU" source measure unit. The output current was read through a "Signal Recovery 7265 DSP" lock-in amplifier.

Fig. 6 shows an exemplary responsivity graph as a function of wavelength for a detector element having quantum dots with an absorption maximum at 1650 nm.

## Claims

1. An imaging sensor (20) comprising a plurality of light-sensitive detector elements (22) being arranged in an array structure, the detector elements (22) comprising quantum dots,
   wherein the average diameter of the quantum dots of the detector elements (22) increase along an array axis of the array structure such that each of the detector elements (22) along the array axis has an absorption maximum at a different pre-determined wavelength.

2. The imaging sensor (20) according to claim 1, wherein each detector element (20) comprises at least two sub-elements (24), wherein all sub-elements (24) of a detector element (22) comprise quantum dots of the same average diameter.

3. The imaging sensor (20) according to claim 1 or 2, wherein the quantum dots comprise a semiconductive material, the semiconductive material preferably being selected from the group consisting of PbS, PbSe, HgTe, InAs, InSb, CdS, CdSe and combinations thereof, more preferably wherein the semiconductive material of the quantum dots is PbS.

4. The imaging sensor (20) according to any of the preceding claims, wherein the quantum dots have a core-shell structure.

5. The imaging sensor (20) according to any of the preceding claims, wherein the average diameter of the quantum dots is within the range of from 3 to 20 nm.

6. The imaging sensor (20) according to any of the preceding claims, wherein the quantum dots have a circular or polygonal shape.

7. The imaging sensor (20) according to any of the preceding claims, wherein the imaging sensor (20) is an NIR imaging sensor, especially wherein the imaging sensor (20) is adapted to detect light having a wavelength in a target range of from 500 to 3000 nm, preferably of from 800 to 2500 nm.

8. The imaging sensor (20) according to claim 7, wherein the imaging sensor (20) has a responsivity of 1 or more over at least 85% of the target range, preferably over at least 90 % of the target range.

9. A sensor system (10) comprising the imaging sensor (20) according to any of the preceding claims being adapted to detect light from an incident light beam (18) and at least one optical element (12) configured to guide the incident light (18) beam onto the imaging sensor (20).

10. A method for manufacturing an imaging sensor (20) comprising a plurality of light-sensitive detector elements (22) being arranged in an array structure, the detector elements (22) comprising quantum dots, the method comprising the steps of:

    a) choosing a plurality of pre-determined wavelengths within a target wavelength range,
    b) providing a quantum dot precursor having an average diameter corresponding to one of the pre-determined wavelengths,
    c) preparing an ink formulation comprising the quantum dot precursor and a solvent, and
    d) applying the ink formulation on a substrate (26), thereby forming one of the plurality of detector elements (22) comprising quantum dots,

    wherein steps b) to d) are repeated for each of the pre-determined wavelengths and wherein the ink formulations are applied on the substrate (26) such that the average diameter of the quantum dots in the formed detector elements (22) increases along an array axis of the array structure.

11. The method of claim 10, wherein the solvent is chosen from the group consisting of N,N-dimethylformamide, hexylamine, butylamine, phenylethylamine, dimethylsulfoxide and combinations thereof.

12. The method of claim 10 or 11, wherein the solvent used in the ink formulation has a boiling point of 130 °C or less.

**13.** The method of any of claims 10 to 12, wherein the quantum dot precursor has a concentration of at least 300 mg/mL in the ink formulation, preferably of at least 400 mg/mL.

**14.** The method of any of claims 10 to 13, wherein the substrate (26) is a finger-structure electrode.

**15.** The method of any of claims 10 to 14, wherein the substrate (26) comprises a metal oxide layer on which the ink formulation is applied.

**Patentansprüche**

**1.** Bildgebungssensor (20), der mehrere lichtempfindliche Detektorelemente (22) umfasst, die in einer Array-Struktur angeordnet sind, wobei die Detektorelemente (22) Quantenpunkte umfassen, wobei der mittlere Durchmesser der Quantenpunkte der Detektorelemente (22) entlang einer Array-Achse der Array-Struktur so zunimmt, dass jedes der Detektorelemente (22) entlang der Array-Achse bei einer anderen vorbestimmten Wellenlänge ein Absorptionsmaximum aufweist.

**2.** Bildgebungssensor (20) nach Anspruch 1, bei dem jedes Detektorelement (20) mindestens zwei Teilelemente (24) umfasst, wobei alle Teilelemente (24) eines Detektorelements (22) Quantenpunkte mit dem gleichen mittleren Durchmesser umfassen.

**3.** Bildgebungssensor (20) nach Anspruch 1 oder 2, bei dem die Quantenpunkte ein halbleitendes Material umfassen, wobei das halbleitende Material vorzugsweise aus der aus PbS, PbSe, HgTe, InAs, InSb, CdS, CdSe und Kombinationen daraus bestehenden Gruppe ausgewählt ist, weiter bevorzugt wobei das halbleitende Material der Quantenpunkte PbS ist.

**4.** Bildgebungssensor (20) nach einem der vorhergehenden Ansprüche, bei dem die Quantenpunkte einen Kern-Mantel-Aufbau aufweisen.

**5.** Bildgebungssensor (20) nach einem der vorhergehenden Ansprüche, bei dem der mittlere Durchmesser der Quantenpunkte im Bereich von 3 bis 20 nm liegt.

**6.** Bildgebungssensor (20) nach einem der vorhergehenden Ansprüche, bei dem die Quantenpunkte eine kreisförmige oder vieleckige Form aufweisen.

**7.** Bildgebungssensor (20) nach einem der vorhergehenden Ansprüche, wobei der Bildgebungssensor (20) ein NIR-Bildgebungssensor ist, insbesondere wobei der Bildgebungssensor (20) dazu ausgebildet ist, Licht mit einer Wellenlänge in einem Zielbereich von 500 bis 3000 nm, vorzugsweise von 800 bis 2500 nm, zu erfassen.

**8.** Bildgebungssensor (20) nach Anspruch 7, wobei der Bildgebungssensor (20) eine Ansprechempfindlichkeit von 1 oder mehr über mindestens 85 % des Zielbereichs, vorzugsweise über mindestens 90 % des Zielbereichs, aufweist.

**9.** Sensorsystem (10) mit dem Bildgebungssensor (20) nach einem der vorhergehenden Ansprüche, der dazu ausgebildet ist, Licht von einem einfallenden Lichtstrahl (18) zu erfassen, und mindestens einem optischen Element (12), das so eingerichtet ist, dass es den Strahl des einfallenden Lichts (18) auf den Bildgebungssensor (20) lenkt.

**10.** Verfahren zur Herstellung eines Bildgebungssensors (20), der mehrere lichtempfindliche Detektorelemente (22) umfasst, die in einer Array-Struktur angeordnet sind, wobei die Detektorelemente (22) Quantenpunkte umfassen, wobei das Verfahren die folgenden Schritte umfasst:

a) Auswählen mehrerer vorbestimmter Wellenlängen innerhalb eines Zielwellenlängenbereichs,
b) Bereitstellen eines Quantenpunktvorläufers mit einem mittleren Durchmesser, der einer der vorbestimmten Wellenlängen entspricht,
c) Zubereiten einer Tintenrezeptur, die den Quantenpunktvorläufer und ein Lösungsmittel umfasst, und
d) Aufbringen der Tintenrezeptur auf ein Substrat (26), wodurch eines der mehreren Detektorelemente (22) gebildet wird, die Quantenpunkte umfassen,

wobei die Schritte b) bis d) für jede der vorbestimmten Wellenlängen wiederholt werden und wobei die Tintenrezepturen so auf das Substrat (26) aufgebracht werden, dass der mittlere Durchmesser der Quantenpunkte in den gebildeten Detektorelementen (22) entlang einer Array-Achse der Array-Struktur zunimmt.

11. Verfahren nach Anspruch 10, bei dem das Lösungsmittel aus der aus N,N-Dimethylformamid, Hexylamin, Butylamin, Phenylethylamin, Dimethylsulfoxid und Kombinationen daraus bestehenden Gruppe ausgewählt wird.

12. Verfahren nach Anspruch 10 oder 11, bei dem das in der Tintenrezeptur verwendete Lösungsmittel einen Siedepunkt von höchstens 130 °C aufweist.

13. Verfahren nach einem der Ansprüche 10 bis 12, bei dem der Quantenpunktvorläufer eine Konzentration von mindestens 300 mg/mL in der Tintenrezeptur aufweist, vorzugsweise von mindestens 400 mg/mL.

14. Verfahren nach einem der Ansprüche 10 bis 13, bei dem das Substrat (26) eine Interdigitalelektrode ist.

15. Verfahren nach einem der Ansprüche 10 bis 14, bei dem das Substrat (26) eine Metalloxidschicht umfasst, auf die die Tintenrezeptur aufgebracht wird.


**Revendications**

1. Capteur d'imagerie (20) comprenant une pluralité d'éléments détecteurs photosensibles (22) agencés selon une structure en réseau, les éléments détecteurs (22) comprenant des points quantiques,
le diamètre moyen des points quantiques des éléments détecteurs (22) augmentant le long d'un axe de réseau de la structure en réseau, de telle sorte que chacun des éléments détecteurs (22) le long de l'axe de réseau présente une absorption maximale à une longueur d'onde prédéterminée différente.

2. Capteur d'imagerie (20) selon la revendication 1, chaque élément détecteur (20) comprenant au moins deux sous-éléments (24), tous les sous-éléments (24) d'un élément détecteur (22) comprenant des points quantiques de diamètre moyen identique.

3. Capteur d'imagerie (20) selon la revendication 1 ou 2, les points quantiques comprenant un matériau semi-conducteur, le matériau semi-conducteur étant de préférence choisi dans le groupe constitué de PbS, PbSe, HgTe, InAs, InSb, CdS, CdSe et de leurs combinaisons, le matériau semi-conducteur des points quantiques étant de préférence PbS.

4. Capteur d'imagerie (20) selon l'une des revendications précédentes, les points quantiques présentant une structure cœur/coquille.

5. Capteur d'imagerie (20) selon l'une des revendications précédentes, le diamètre moyen des points quantiques étant compris dans la plage de 3 à 20 nm.

6. Capteur d'imagerie (20) selon l'une des revendications précédentes, les points quantiques présentant une forme circulaire ou polygonale.

7. Capteur d'imagerie (20) selon l'une des revendications précédentes, le capteur d'imagerie (20) étant un capteur d'imagerie NIR, le capteur d'imagerie (20) étant en particulier apte à détecter de la lumière présentant une longueur d'onde dans une plage cible de 500 à 3000 nm, de préférence de 800 à 2500 nm.

8. Capteur d'imagerie (20) selon la revendication 7, le capteur d'imagerie (20) présentant une sensibilité de 1 ou plus sur au moins 85 % de la plage cible, de préférence sur au moins 90 % de la plage cible.

9. Système de capteurs (10) comprenant le capteur d'imagerie (20) selon l'une des revendications précédentes, apte à détecter de la lumière provenant d'un faisceau lumineux incident (18) et au moins un élément optique (12) réalisé de manière à guider le faisceau lumineux incident (18) sur le capteur d'imagerie (20).

10. Procédé de fabrication d'un capteur d'imagerie (20) comprenant une pluralité d'éléments détecteurs photosensibles (22) agencés selon une structure en réseau, les éléments détecteurs (22) comprenant des points quantiques, le procédé comprenant les étapes suivantes :

a) le choix d'une pluralité de longueurs d'onde prédéterminées dans une plage de longueurs d'onde cible,

b) la fourniture d'un précurseur de points quantiques présentant un diamètre moyen correspondant à l'une des longueurs d'onde prédéterminées,

c) la préparation d'une formulation d'encre comprenant le précurseur de points quantiques et un solvant, et

d) l'application de la formulation d'encre sur un substrat (26), formant ainsi l'un des plusieurs éléments détecteurs (22) comprenant des points quantiques,

les étapes b) à d) étant répétées pour chacune des longueurs d'onde prédéterminées, et les formulations d'encre étant appliquées sur le substrat (26) de sorte que le diamètre moyen des points quantiques dans les éléments détecteurs réalisés (22) augmente le long d'un axe de réseau de la structure en réseau.

11. Procédé selon la revendication 10, le solvant étant choisi dans le groupe constitué de N,N-diméthylformamide, d'hexylamine, de butylamine, de phényléthylamine, de diméthylsulfoxyde et de leurs combinaisons.

12. Procédé selon la revendication 10 ou 11, le solvant utilisé dans la formulation d'encre présentant un point d'ébullition de 130 °C ou moins.

13. Procédé selon l'une des revendications 10 à 12, le précurseur de points quantiques présentant une concentration d'au moins 300 mg/mL dans la formulation d'encre, de préférence d'au moins 400 mg/mL.

14. Procédé selon l'une des revendications 10 à 13, le substrat (26) étant une électrode à structure à doigts.

15. Procédé selon l'une des revendications 10 à 14, le substrat (26) comprenant une couche d'oxyde métallique sur laquelle la formulation d'encre est appliquée.

## Fig. 1

## Fig. 2

## Fig. 3

## Fig. 4

## Fig. 5

## Fig. 6

Fig. 7

**EP 4 407 685 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008315339 A1
- EP 3979333 A1
- US 2005205879 A1
- US 2018342647 A1